# EUROPEAN PATENT SPECIFICATION

(11) **EP 3 343 722 B1**
(45) Date of publication and mention of the grant of the patent: **28.04.2021**
(21) Application number: 16207299.5
(22) Date of filing: 29.12.2016
(51) Int. Cl.: H02J 7/00, G01R 35/00

(54) **METHOD FOR THE MANUFACTURING OF A BATTERY SYSTEM**
VERFAHREN ZUR HERSTELLUNG EINES BATTERIESYSTEMS
PROCÉDÉ DE FABRICATION D'UN SYSTÈME DE BATTERIE

(43) Date of publication of application: 04.07.2018
(73) Proprietor: Samsung SDI Co., Ltd., Yongin-si, Gyeonggi-do 17084 (KR)
(72) Inventor: Hofer, Maximilian, 8230 Hartberg (AT); Erhart, Michael, 8054 Seiersberg (AT)
(74) Representative: Gulde & Partner

(56) References cited:
- DE-A1-102014 220 079
- MAX JUNG ET AL: "Abstract", GREEN, vol. 3, no. 1, 15 January 2013 (2013-01-15), XP055390089, ISSN: 1869-876X, DOI: 10.1515/green-2012-0028
- Intersil: "Optimizing Battery Accuracy for EVs and HEVs Introduction", , 1 January 2016 (2016-01-01), XP055390253, Retrieved from the Internet: URL:http://www.intersil.com/content/dam/In tersil/whitepapers/battery-management/opti mizing-battery-accuracy-for-evs-and-hevs.p df [retrieved on 2017-07-12]

## Description

### Field of the Invention

The present invention relates to a method for the manufacturing of a battery system. The method comprises the steps of providing a Battery Management System, BMS chip; assembling a Printed Circuit Board, PCB; connecting and fixing the BMS chip to the PCB, to form a Cell Supervision Circuit, CSC; mounting the CSC onto one battery module of a plurality of battery modules, connecting the PCB of the CSC to at least one battery cell of the at least one battery module; and electrically interconnecting the at least one battery module and another one of the plurality of battery modules and electrically connecting the CSC to a control unit.

### Technological Background

In battery systems of the state of the art, a plurality of electronic components come to use. One of these components is a so called Cell Supervision Circuit, CSC, which comprises a so called Battery Management System, BMS chip that is fixed and connected to a Printed Circuit Board, PCB. This BMS chip is often provided as an analog front-end, AFE chip and provides for a plurality of functions as for example the measurement of voltages or of other parameters of battery cells connected thereto. In the state of the art, the calibration of most BMS chips is performed in the package of the BMS chip at the semiconductor manufacturer, before the BMS chip is mounted to the PCB. Sometimes, also a burn in process and/or a backing process is performed before the BMS chip is calibrated.

However, as further thermal steps follow to the packaging of the BMS chip and as the BMS chip is not supplied with a voltage or a current before it is mounted to a PCB that is connected to a battery module, the BMS chips of the state of the art need to be provided with a non-volatile memory, NVM, respectively, as for example with an e-fuse, a flash EEPROM circuit or other non-volatile RAM or ROM structures, in order to store the calibration data of the BMS chip therein. To realize those in part complex e-fuse or non-volatile RAM/ROM structures, a plurality of additional process steps are needed in the production of a BMS chip which results in higher costs of production. Furthermore, a part of the thermal budget available when producing the BMS chip needs to be used for the aforementioned process steps. The following publications disclose BMS architecture and methods of calibrating sensors of a BMS.

MAX JUNG ETAL: "Abstract",GREEN, vol. 3, no. 1, 15 January 2013 (2013-01-15), ISSN: 1869-876X, DOI: 10.1515/green-2012-0028

Intersil: "Optimizing Battery Accuracy for EVs and HEVs Introduction",, 1 January 2016 (2016-01-01), URL:http://www.intersil.com/content/dam/Intersil/whitepapers/battery-management/ optimizing-battery-accuracy-for-evs-and-hevs.pdf

DE 10 2014 220079 A1 (BOSCH GMBH ROBERT

### Summary of Invention

One or more of the drawbacks of the prior art could be avoided or at least reduced by means of the present invention. In particular, a method for the manufacturing of a battery system is provided. The method comprises the steps of providing a Battery Management System, BMS chip with a volatile memory unit; assembling a Printed Circuit Board, PCB and connecting and fixing the BMS chip to the PCB, to form a Cell Supervision Circuit, CSC. Furthermore, the method comprises the steps of mounting the CSC onto one battery module of a plurality of battery modules and connecting the PCB of the CSC to at least one battery cell of the at least one battery module. Moreover, the method comprises the step of electrically interconnecting the at least one battery module and another one of the plurality of battery modules and electrically connecting the CSC to a control unit. According to the invention, the step of mounting and/or the step of electrically interconnecting further comprises the step of calibrating the BMS chip, wherein the step of calibrating is performed when the BMS chip is supplied with power from the at least one battery cell, the data resulting from the calibration being stored within the volatile memory unit.

With such a method for the manufacturing of a battery system, the BMS chip does not need to be provided with a non-volatile memory, as the calibration of the BMS chip is performed when the BMS-chip is constantly supplied with energy from battery cells of the battery system. Expressed in other words, when the PCB with the BMS chip thereon is connected to the battery cells of the battery modules of the battery system, the BMS chip is constantly supplied with energy until the rest of the life of the battery system that is manufactured with the method according to the invention. Thus, the calibration data that is gathered during the calibration of the BMS chip can be stored in a simple volatile memory, VM unit as for example in a SRAM Cell device comprising 6 Transistors per SRAM cell. Therefore, the calibration data does not have to be stored in a non-volatile memory device or unit as an e-fuse or an EEPROM flash as it is done in the state of the art. This allows for a reduction of costs in the manufacturing of battery systems.

Moreover, as the calibration of the BMS chip is performed after the BMS chip has been fixed to the PCB, the accuracy of the calibration will be higher and more stable over the life time of the BMS chip, since most fixation processes - as for example a soldering process - involve a thermal treatment which negatively influences the analog performance and thus the accuracy of the BMS chip when performed after the calibration of the BMS chip.

Preferably, the step of calibrating is performed after the BMS chip has been fixed to the PCB and connected thereto. Furthermore preferred, in the step of electrically interconnecting the at least one battery module and another one of the plurality of battery modules is performed using at least one bus bar.

In a preferred embodiment, the method further comprises the step of providing for a further CSC to be mounted on the another one of the plurality of battery modules, wherein in the step of electrically interconnecting, also the CSCs are electrically interconnected. In such an embodiment of the method, the CSCs of a plurality of battery modules can be calibrated using the same reference signal or voltage.

Preferably, the step of connecting and fixing comprises the step of soldering the BMS chip to the PCB. Furthermore preferred, the step of connecting and fixing comprises the step of thermally fixing the BMS chip to the PCB. In such an embodiment, the soldering is performed before the BMS chip is calibrated which increases and maintains the accuracy of the BMS chip.

Preferably, the control unit is any unit that is adapted to provide for a reference voltage or for a reference signal or for a sequence of predefined voltage pulses.

Preferably, the provided BMS chip comprises a plurality of channels for the measurement of at least one battery cell parameter and a plurality of communication ports for the communication with at least one external component, wherein the step of calibrating comprises the step of triggering a calibration process of the BMS chip for an automatic calibration of the plurality of channels. In such an embodiment, an automatic calibration of the BMS chip can easily be triggered. Preferably, the BMS chip is adapted to perform an automatic calibration of the plurality of channels.

In a preferred embodiment, at least one of the communication ports is used for the calibration of the BMS chip in the step of calibrating. In such an embodiment, it is not needed to provide the BMS chip with additional input terminals for the initiation of a calibration process. Furthermore, the calibration of the BMS chip is fundamentally simplified.

Preferably, the step of triggering comprises detecting a predefined signal supplied to the at least one of the communication ports. Furthermore preferred, within the step of triggering, a calibration of the channels of the BMS chip is triggered upon the detection of a predefined signal supplied to the at least one of the communication ports. Preferably, the step of triggering comprises detecting a predefined signal supplied to the at least one of the communication ports. In such an embodiment, the triggering of the calibration can efficiently and easily be performed via for example a communication wire that is connected to the communication port. Preferably, the communication port is electrically connected to a supply source that is adapted to provide for a predefined reference voltage for the triggering of a calibration and for the calibration of the BMS chip.

Furthermore preferred, the predefined signal is a 4V direct current, DC, signal.

As preferably a signal of 4.0000V is used for and within the calibration process which follows the step of triggering, about the same signal that is used as an analog reference signal within the calibration can advantageously be used to trigger the calibration itself, which eases the calibration of the BMS chip.

Preferably, the predefined signal is a 1V DC signal, a 2V DC signal, a 3V DC signal, a 5V DC signal, a 6V DC signal, a 7V DC signal or a 8V DC signal. In a preferred alternative embodiment, the step of triggering comprises the step of detecting a predefined sequence of voltages or of voltage pulses of a predefined duration and/or amplitude respectively, the voltages or voltage pulses being supplied to the at least one of the communication ports of the BMS chip. Furthermore preferred, within the step of triggering, a calibration of the channels of the BMS chip is triggered upon the detection of a predefined sequence of voltages or of voltage pulses of a predefined duration and/or amplitude respectively.

Furthermore preferred, the step of calibrating further comprises the step of, consecutively to the step of triggering, using the at least one of the communication ports for the supply of an analog reference voltage in the calibration process triggered. Expressed in other words, after the predefined signal or the predefined sequence is detected and the calibration of the BMS chip is triggered, an external analog reference voltage is supplied to at least one of the communication ports of the BMS chip to be used for the calibration of the channels of the BMS chip. In such an embodiment, at least one communication port is advantageously used for a calibration of the channels of the BMS chip so that the BMS chip does not need to be provided with additional input terminals for a calibration. The reference voltage for the calibration instead is directly supplied to the BMS chip via for example a communication wire that is connected to the communication port.

Preferably, the external analog reference voltage has a value of 4.0000V. In other embodiments, the external analog reference voltage or reference signal preferably has a value of 1.0000V, of 2.0000V, of 3.0000V, of 5.0000V, of 6.0000V, of 7.0000V or of 8.0000V.

In a preferred embodiment, the at least one of the communication ports is not used for a communication of or with the BMS chip as long as the step of calibrating is performed. Moreover preferred, the at least one of the communication ports that is used for a calibration within the step of calibrating is not used for a communication of or with the BMS chip as long as the step of calibrating is performed. In such an embodiment, the calibration cannot be interrupted by an attempt of either for example an external component to communicate with the BMS chip or by an attempt of the BMS chip to communicate with another component. This will assure a precise performance of the calibration of the BMS chip.

Preferably, at least one of the channels of the BMS chip is connected to an input terminal of an Analog-to-Digital Converter, ADC or to a multiplexer circuit that is connected to an input terminal of an ADC via a calibration switch respectively, and wherein the calibration switch allows to switch the input terminal of the ADC of the BMS chip to the at least one of the communication ports, wherein the step of calibrating further comprises the step of switching the input terminal of the ADC of the BMS chip to the at least one of the communication ports. In such an embodiment, the precise reference signal of for example 4.0000V can be switched to the input terminal of the ADC, allowing for a calibration of the respective channel allocated to the ADC. Preferably, all channels of the BMS chip are allocated one ADC and calibrated via the analog reference voltage provided to the at least one of the communication port of the BMS chip.

Moreover preferred, the method further comprises the step of storing the result of the calibration within the volatile memory, VM unit of the BMS chip. Preferably, the volatile memory, VM unit is a RAM unit that comprises at least one SRAM cell. Preferably, the at least one SRAM cell comprises 6 transistors. Furthermore preferred, the RAM unit is an SRAM storage device. In such an embodiment, the result of the calibration can easily, quickly and cost efficient be stored in a simple volatile memory, VM unit. The current consumption of an SRAM storage device is very low. Especially, at analogue processes, the current consumption of an SRAM storage device is negligible.

Furthermore, a battery system is provided. The battery system comprises at least two battery modules electrically interconnected via at least one bus bar, each battery module comprising at least one battery cell. Furthermore, the battery system comprises a Cell Supervision Circuit, CSC per battery module respectively, wherein each CSC comprises a Printed Circuit Board, PCB, and a Battery Management System, BMS chip comprising a volatile memory unit, respectively. According to the invention, the battery system has been manufactured with a method that is according to the invention. As a method according to the invention comes to use when the battery system is manufactured, the manufacturing of the battery system is less expensive, as no NVM process is needed in the manufacturing of the BMS chip. Furthermore, the battery system is more reliable, as the BMS chip provided is not heated up after it has been calibrated, which allows for a more precise calibration that is more stable over lifetime of the BMS chip.

Preferably, the BMS chip comprises an Analog-to-Digital Converter, ADC with an input terminal, a plurality of channels for the measurement of at least one battery cell parameter, a plurality of communication ports for the communication with at least one external component, at least one calibration switch, adapted to electrically connect the input terminal of the ADC to either one of the plurality of communication ports or to at least one of the plurality of channels. Preferably, the ADC is adapted to be used within a calibration of the BMS chip. Preferably, the ADC is adapted to automatically perform the calibration of the channels of the BMS chip upon a triggering of the BMS chip. Preferably, the at least one calibration switch is adapted to electrically connect the input terminal of the ADC to either one of the plurality of communication ports or to at least one of the channels. Preferably, the BMS chip has as many ADCs and calibration switches as it has channels. In an alternative embodiment, the BMS chip preferably comprises only one ADC with an input terminal connected to a multiplexer circuit, MUX, that is electrically connected to at least one, preferably all of the channels of the BMS chip. Such a multiplexer circuit allows to share one ADC for all the channels of the BMS chip.

Such a battery system is cost efficient and the BMS chip can easily be calibrated. Furthermore, fewer components come to use as a non-volatile memory can be omitted. Preferably, the BMS chip only comprises a volatile memory, VM unit as a storage unit for the storage of calibration data. Furthermore preferred, no calibration data is stored in a non-volatile storage unit of the BMS chip.

Furthermore preferred, the battery system comprises at least two CSCs with a BMS chip respectively, wherein at least one of the plurality of the communication ports of a first of the BMS chips is electrically connected to a Battery Monitor Unit providing for an accurate reference voltage and/or wherein at least one other one of the plurality of the communication ports of the first of the BMS chips is electrically connected to at least one of the plurality of communication ports of the second of the BMS chips. In such an embodiment, the BMS chips of both CSCs can be calibrated using only one analog reference voltage that is transferred from CSC to CSC via communication wires that are connected to the communication ports of the BMS chips respectively. In such an embodiment, the analog reference voltage is handed over from one CSC to another CSC and from one BMS chip to another BMS chip. This fundamentally eases the calibration of all the BMS chips of a battery system which causes a substantial reduction in costs of battery system manufacturing.

Moreover preferred, a vehicle including a battery system that is according to the invention is provided. In such an embodiment, the aforementioned advantages come to fruition in the context of vehicle manufacturing. Furthermore, in the context of especially electric vehicles, among others a stable calibration of the BMS chip is important among others in order to reliably be able to estimate the operational distance that can be reached with the vehicle comprising the respective battery system.

Further aspects of the present invention could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a method for the manufacturing of a battery system according to an embodiment;
- Fig. 2: illustrates the calibration of a BMS chip of a CSC as a step of a method according to an embodiment;
- Fig. 3: illustrates a BMS chip that is calibrated within the step of calibrating of a method according to an embodiment;
- Fig. 4: illustrates a diagram showing the exposure of the BMS chip to different temperatures during the manufacturing of the battery system according to an embodiment, and
- Fig. 5: illustrates the calibration of a battery system with a plurality of Cell Supervision Circuits with a method that is according to an embodiment.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

Features of the inventive concept and methods of accomplishing the same may be understood more readily by reference to the following detailed description of embodiments and the accompanying drawings. Hereinafter, example embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described.

It will be understood that when an element is referred to as being "on," "connected to," or "coupled to" another element, it can be directly on, connected to, or coupled to the other element, or one or more intervening elements may be present. In addition, it will also be understood that when an element is referred to as being "between" two elements, it can be the only element between the two elements, or one or more intervening elements may also be present.

The terminology used herein is for the purpose of describing particular embodiments only and is not intended to be limiting of the present invention. As used herein, the singular forms "a," "an," and "the" are intended to include the plural forms as well, unless the context clearly indicates otherwise. It will be further understood that the terms "comprises," "comprising," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of e.g. +/- 5% of the value centered on the value. Further, the use of "may" when describing embodiments of the present invention refers to "one or more embodiments of the present invention." Herein, the terms "upper" and "lower" are defined according to the z-axis. For example, the cover is positioned at the upper part of the z-axis, whereas the ground plate is positioned at the lower part thereof.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein.

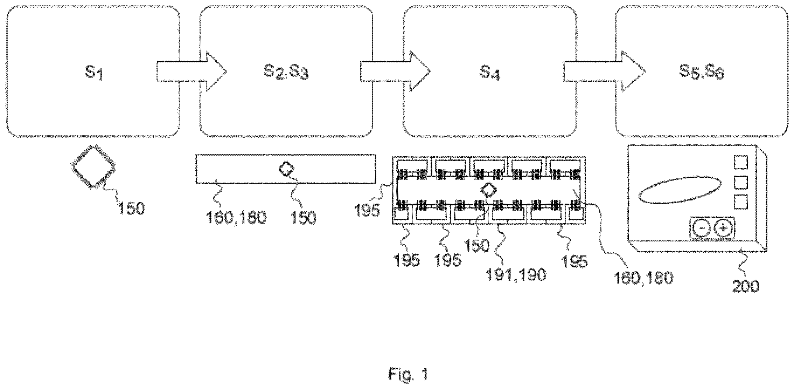

Figure 1 illustrates a method for the manufacturing of a battery system 200 according to an embodiment. The method comprises a plurality of steps which will be described in the following:
According to a first step S₁ of the method, it is provided a Battery Management System, BMS chip 150. This BMS chip 150 can for example be a chip that is produced as an integrated circuit, IC and provided by a semiconductor manufacturer. In this embodiment, within the first step S₁ of providing the BMS chip 150, different tests are performed on the wafer used for the production of the BMS chip. Afterwards, the BMS chip 150 is packaged and a baking in and a burn in procedure is performed with the BMS chip 150. However, the first step S₁ of providing can also differ from the first step S₁ as described hereinbefore. In more detail, the first step S₁ can e.g. also be performed without a baking in procedure and without a burn in procedure, or either with a baking in procedure or a burn in procedure.

Furthermore, the method comprises the second step S₂ of assembling a Printed Circuit Board, PCB 160. The PCB 160 is assembled to form a component of a Cell Supervision Circuit, CSC 180.

In a third step S₃ of the method, the BMS chip 150 is connected and fixed to the PCB 160. Expressed in other words, within the third step S₃ of the method according to the embodiment of the invention described herein, the BMS chip 150 is electrically connected to the PCB 160 and mounted thereto. The mounting can comprise a reversible or an irreversible fixation procedure which may comprise a thermal procedure or step. In this embodiment, the BMS chip 150 is exemplarily soldered to the PCB 160 to form the CSC 180. As such soldering processes causes a decrease in the analogue performance of the BMS chip 150, other processes for the mounting or fixation of the BMS chip 150 to the PCB 160 may come to use within the third step S₃ of the method in order to form the finalized CSC 180.

In a fourth step S₄ of the method, the CSC 180 is mounted onto one battery module 191 of a plurality of battery modules 190 of which in figure 1 only the one battery module 191 is shown. Furthermore, also in the fourth step S₄ of the method, the PCB 160 of the CSC 180 is electrically connected to the battery cells 195 of the one battery module 191. In this embodiment of the method, the CSC 180 is electrically connected to all of the battery cells 195 of the aforementioned battery module 191. However, in other embodiments, the CSC 180 can also be connected to only one battery cell 195 or to more than one but not to all battery cells 195 of the battery module 191. Furthermore, in other embodiments, a plurality of CSCs are assembled according to the aforementioned method comprising the first, second and third step S₁, S₂, S₃, wherein each CSC is connected to one battery module of the plurality of battery modules 190 respectively. With this fourth step S₄ of the method, the BMS chip 150 is provided with a last so called start up. Thus, from the moment on the CSC 180 is connected to the battery module 191, until the end of life of the battery system 200, the BMS chip 150 is supplied with a voltage and is therefore in a powered state.

In a fifth step S₅ of the method, the at least one battery module 191 and another one of the plurality of battery modules 191 (not shown in figure 1) are electrically interconnected. Thus, in the fifth step S₅ of the method, for example via the terminals of the battery module 191 (not shown), the battery module 191 is electrically connected to another battery module of the plurality of battery modules 190. Furthermore, also in the fifth step S₅ of the method, the CSC 180 is electrically connected to a control unit (not shown). In this first embodiment, the control unit exemplarily is a Battery Control Unit, BCU. However, the control unit can also be any other unit adapted to provide for a reference voltage or for a reference signal. The control unit may be adapted to manage the CSC 180 or the CSC 180 may be adapted to communicate measured values of a battery cell 195 of the battery module 191 to the control unit. Furthermore, in an embodiment, in which more than one battery module 190 comprises a CSC respectively, the CSCs are electrically interconnected. In this embodiment of the method, the battery modules 191, 190 are electrically interconnected using bus bars. However, in other embodiments, other devices or units may be used for an electrical interconnection in the fifth step S₅ of the method according to the invention.

Furthermore, in this embodiment of the method, the fifth step S₅ of electrically interconnecting the battery modules 191, 190 exemplarily further comprises a sixth step S₆ of calibrating the BMS chip 150. Thus, the sixth step S₆ of calibrating is performed after the aforementioned battery modules 191, 190 are electrically interconnected and after the CSC 180 has been electrically connected to the control unit. However, in other embodiments of the method, the sixth step S₆ of calibrating can also be performed during the fifth step S₅ of electrically interconnecting the battery modules 191, 190 or during the step of electrically connecting the CSC 180 to a control unit (not shown).

Moreover, in other embodiments of the method, the sixth step S₆ of calibrating is performed after the CSC 180 has been mounted onto the one battery module 191 of the plurality of battery modules 190 and after the PCB 160 of the CSC 180 is connected to the battery cells 195 of the battery module 191. In such an embodiment, the calibration of the BMS chip 150 can be performed as soon as the BMS chip 150 is provided with a voltage of the battery cells 195 of the battery module 191.

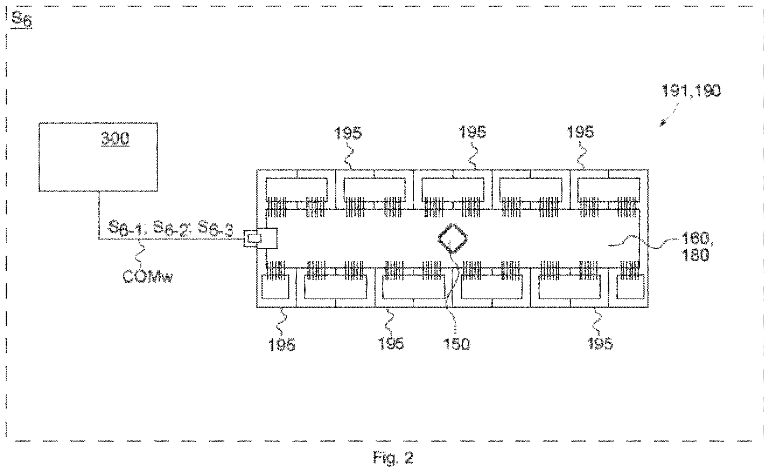

The calibration of the BMS chip 150 that is performed within the sixth step S₆ of the method will be described with respect to the figures 2, 3, 4 and 5.

In figure 2, the electrical connection of a control unit 300 to the CSC 180 and thus to the BMS chip 150 of the aforementioned battery system 200 is illustrated. While in this embodiment the CSC 180 is electrically connected to a control unit 300, the CSC 180 may also be connected to any other unit or voltage source which is adapted to output a precise reference voltage or reference signal for the purpose of a calibration.

In this embodiment, the CSC 180 is electrically connected to the control unit 300 via a communication wire COMw, which - before and after the calibration is performed - is used for the communication of the CSC 180 with other components of for example the battery system 200. The communication wire COMw is electrically connected to a communication port (not shown) of the BMS chip 150, allowing for the calibration of the BMS chip 150 in the sixth step S₆ of the method.

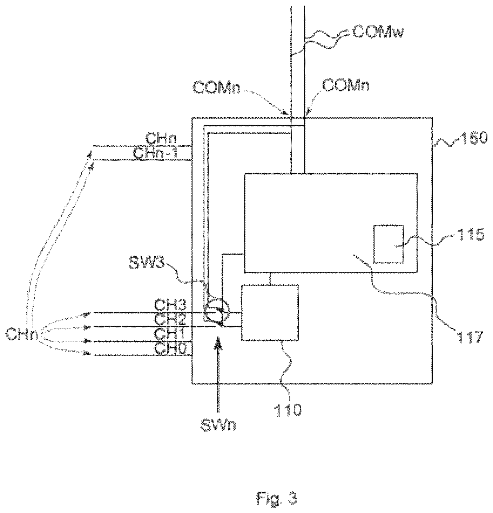

The BMS chip 150 provided in the first step S₁ of the method is shown in figure 3. In this embodiment, the provided BMS chip 150 comprises n channels CHn for the measurement of at least one battery cell parameter and a plurality of communication ports COMn for the communication with at least one external component. The channels CHn of the BMS chip 150 are electrically connected to battery cells 195 of the battery module 191, 190 via the PCB 160. In more detail, each channel CHn is connected to a pin, allowing for an eased electrical connection to a battery cell 195.

In figure 3, only two of the plurality of communication ports COMn are illustrated for the sake of a better understanding. The BMS chip 150 shown in figure 3 is adapted for an automatic calibration. However, the calibration of the BMS chip 150 can also be performed by for example a logical unit which may be external to the BMS chip 150.

In this embodiment of the method, the step of calibrating S₆ comprises the step of triggering S₆₋₁ a calibration process of the BMS chip 150 for an automatic calibration of the plurality of channels CHn, using one of the calibration ports COMn shown in figure 3. In more detail, in this embodiment, the step of triggering S₆₋₁ comprises the step detecting S₆₋₂ a predefined signal supplied to the aforementioned communication port COMn. The signal in this embodiment exemplarily is a 4V DC signal which is supplied to the BMS chip 150 by the control unit 300 that is electrically connected to the aforementioned communication port COMn of the BMS chip 150 via the communication wire COMw (see figure 2). In an other embodiment that is according to the invention, the step of triggering S₆₋₁ comprises the step of detecting S₆₋₂ a predefined sequence of voltage pulses supplied to the aforementioned communication port COMn, e.g. during a communication with the control unit 300 that is electrically connected to the aforementioned communication port COMn of the BMS chip 150 via the communication wire COMw.

Expressed in other words, in this embodiment, the BMS chip 150 is electrically connected to a control unit 300 via a communication wire COMw connected to a communication port COMn of the BMS chip 150, wherein in the sixth step S₆ of the method, the control unit 300 is adapted to trigger an automatic calibration of the BMS chip 150 by the transmittance of a predefined signal - here, a 4V DC signal -which is detected on the communication wire COMw connected to the communication port COMn of the BMS chip 150 or which is detected directly at the communication port COMn of the BMS chip 150. The invention is not limited to the detection of 4V DC signals. Also other embodiments of methods that are according to the invention can be carried out in which the step of triggering S₆₋₁ is performed by detecting any other signal, for example a 2V AC signal, a 9.5V DC signal or any other signal.

In this embodiment of the method, the sixth step S₆ of calibrating further comprises the step of, consecutively to the step of triggering S₆₋₁, using S₆₋₃ the aforementioned communication port COMn for the supply of an analog reference voltage in the calibration process triggered. Thus, the same communication port COMn and communication wire COMw via which the calibration process has been triggered is used for the supply of an analog reference voltage which is also supplied to the communication port COMn and communication wire COMw via the control unit 300. Thus, shortly after the 4V DC trigger signal has been detected, the external voltage reference has to be switched to the communication wire COMw / communication ports COMn to provide for the reference voltage for the actual calibration process. Once the calibration process is triggered via the sub-steps S₆₋₁ and S₆₋₂, the BMS chip 150 will do an automatic calibration of the channels CHn of the BMS chip 150, still using the communication port COMn and the communication wire COMw that has been used during the sub-step of triggering S₆₋₁.

In this embodiment, the control unit 300 is adapted to provide for a precise analog reference voltage or signal of 4.0000V. However, the invention is not limited to such analog reference voltages/signals. In fact, any other analog reference voltage or signal may be used within a method that is according to the invention. For example, a reference voltage of 4.000V, of 4.00000V, of 3.5000V or of 8.9000V may be used. In this embodiment of the method, the communication port COMn and communication wire COMw is not used for a communication of or with the BMS chip 150 as long as the step of calibrating S₆ is performed. Thus, when the calibration is triggered, the aforementioned communication port COMn is not used for a communication anymore, but as an analog reference for the calibration process.

In this embodiment, the channels CHn of the BMS chip 150 are exemplarily connected to an Analog-to-Digital Converter, ADC 110 respectively. Thus, each channel CHn of the BMS chip 150 is allocated to one ADC 110 respectively. In figure 3, only the ADC 110 for the third channel CH3 of the plurality of channels CHn is illustrated for the sake of a better understanding. In a normal mode of operation of the BMS chip 150 - in that a calibration is not performed - the voltage measured between the second and the third channel CH2, CH3 of the plurality of channels is used to measure or calculate the voltage of a battery cell 195 or a voltage between two other potentials of the battery module 191 or of the battery system 200. In contrary to that, in a so called calibration mode of the BMS chip 150, the input terminal of the ADC 110 allocated to the third channel CH3 is internally disconnected from the channel CH3 and connected to the external reference signal feed supplied to and into the BMS chip 150 via the aforementioned communication wire COMw and communication port COMn.

In order to allow for such a connection in the calibration mode, each electrical connection of a channel CHn to a corresponding ADC 110 comprises a calibration switch SWn respectively, the calibration switch SWn allowing to switch the input terminal of the respective ADC 110 of the BMS chip 150 to the communication port COMn supplying the reference voltage/signal respectively.

For example, - in case of the third channel CH3 - a calibration switch SWn - in this case SW3 - in between the analog input/the third of the channels CH3 and the ADC 110 for the third of the channels CH3 is switched to the communication port COMn supplying the reference signal/voltage. In such a situation, the respective calibration switch SWn allocated to the respective channel CHn is in a so called calibration position. As soon as the calibration switch SWn allocated to a channel CHn is transferred into this calibration position, the ADC allocated to the respective channel CHn is connected to the aforementioned communication port COMn and starts an automatic calibration. In this embodiment, the ADCs as the ADC 110 are electrically connected to a digital logic unit 117 which is adapted to operate the components of the BMS chip 150, as for example the ADC 110, according to a predefined operation scheme.

Therefore, the sixth step S₆ of calibration further comprises the sub-step of switching S₆₋₄ the input terminal of the ADC 110 of the BMS chip 150 to the at least one of the communication ports COMn. Thus, all of the ADCs 110 of the BMS chip 150 can be switched to the at least one of the communication ports COMn, allowing for a calibration of all of the channels CHn of the BMS chip 150. In other embodiments of the method which are also according to the invention, the BMS chip 150 comprises only one ADC 110 with an input terminal connected to a multiplexer circuit, MUX, that is electrically connected to one, a few or all of the channels CHn of the BMS chip 150. In such embodiments, the input terminals of the multiplexer circuit, MUX are provided with a calibration switch SWn respectively, allowing to switch an input terminal of the multiplexer circuit, MUX to the aforementioned communication port COMn supplying the reference signal respectively. Also in such an embodiment, the calibration of the channels CHn can be performed by the ADC 110.

Moreover, in this embodiment, the sixth step S₆ of calibrating further comprises the sub step of storing S₆₋₅ the result of the calibration within a volatile memory, VM unit 115, which in this embodiment exemplarily is realized as a RAM unit that is realized as an SRAM chip. As the BMS chip 150 is - until the end of the life of the battery system - constantly provided with power, the data resulting from the calibration is stored within the volatile memory, VM unit 115 as long as needed.

Thus, once the calibration process is done, the result is the digital representation of the external reference voltage. The result is stored in an SRAM, but can also be stored in any other volatile memory. In some embodiments, an aforementioned calibration switch SWn can also be transferred into a third position allowing for a zero point calibration of the channels CHn. In more detail, such a third position allows to shortcut the input terminal of the ADC 110.

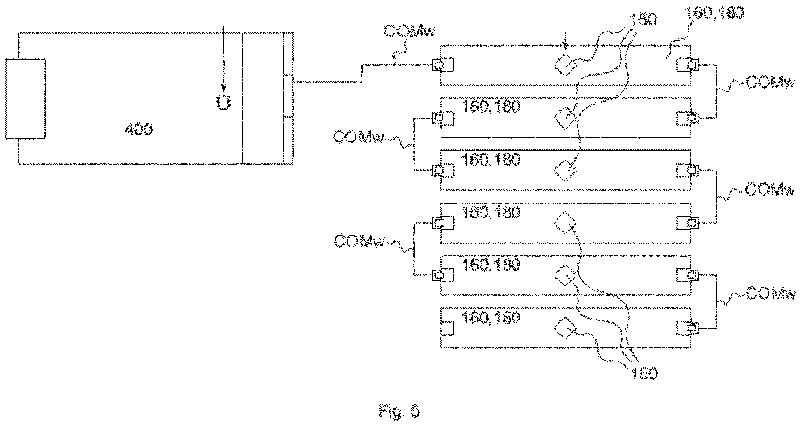

Expressed in other words, the aforementioned BMS chip 150 is provided with a calibration mode and can be switched into this special calibration mode. In the calibration mode, the BMS chip 150 switches the input terminals of the ADCs 110 not to the pins of the external channels CHn but to the reference voltage feed externally supplied into the BMS chip 150 via the communication ports COMn. In the calibration mode, the communication port COMn supplied with the reference voltage or signal is used as a source for a reference. The coupling of the communication port COMn is bypassed during the calibration. If a daisy chain of battery modules 190 is provided, the BMS chip 150 has to feed through the reference voltage at the input to the output port, which will be described in greater detail with respect to figure 5.

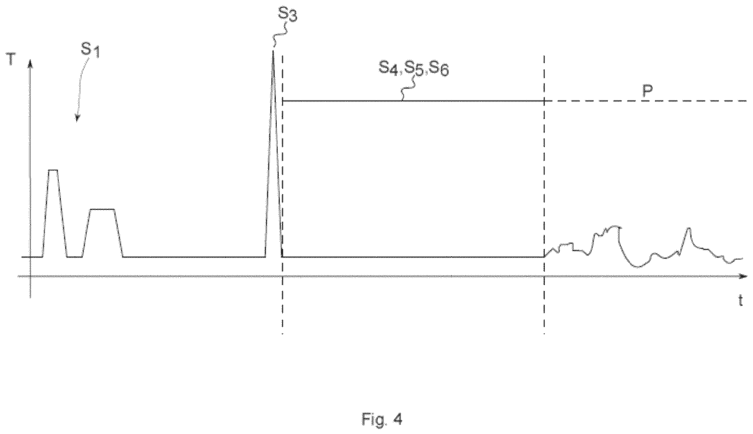

In figure 4, a diagram is illustrated showing the exposure of the BMS chip 150 to different temperatures during the manufacturing of the battery system 200. Expressed in other words, figure 4 shows a temperature profile with a range from -40°C up to 300°C during the buildup workflow of the battery system 200.

During the first step S₁ of the method, the BMS chip 150 is provided which in this embodiment comprises the manufacturing or production of the BMS chip 150. The lowest temperature of about -40°C is reached when the BMS chip 150 is tested during its manufacturing/production (not shown in figure 4). However, the BMS chip 150 is exposed to high temperatures during the step of baking and during the burn in process, which also forms a part of the manufacturing of the BMS chip 150. The high temperatures during the baking/burn in process influence the analogue performance of the BMS chip 150. During the third step S₃ of connecting and fixing the BMS chip 150 to the PCB 160, the BMS chip 150 is exposed to a temperature of 300°C when the fixing is performed via soldering. Consequently, the analogue performance of the BMS chip 150 will be changed again. After the third step S₃, the fourth and fifth steps S₄, S₅ are performed.

The calibration of the BMS chip 150 is performed during the sixth step S₆ of the method, after the third step S₃ of the method has been completed, as after the step of soldering, the BMS chip 150 is merely exposed to moderate temperatures. This allows for a more precise calibration that is not distorted by the exposure of the BMS chip 150 to high temperatures in following steps of the method. For example, during the performance of the fourth and fifth step S₄, S₅ of the method, the maximal storage temperature of the battery system 200 that is allowed is equal to 85°C. Furthermore, also during operation of the battery system 200, an environment temperature up to 85°C is allowed. The maximal junction temperature is usually 150°C which is not reached in the field. If the balancing of battery cells 195 of a battery module 190, 191 is done using the BMS chip 150, a maximal temperature of 125°C is allowed.

The last period denoted p within the diagram shown in figure 4 shows an exemplary temperature profile given during operation of the BMS chip 150.

Figure 5 illustrates the calibration of a battery system 200 with a plurality of Cell Supervision Circuits 180 with a method that is according to an embodiment of the invention. The CSCs 180 in this embodiment are connected to battery modules (not shown in figure 5) respectively. Each CSC 180 comprises a BMS chip 150 respectively. The CSCs 180 are electrically connected with each other in a so called daisy chain, wherein one of the plurality of the communication ports (not shown in figure 5) of the BMS chip 150 of the first CSC 180 is electrically connected to a Battery Monitor Unit 400 via a communication wire COMw, the Battery Monitor Unit 400 providing for an accurate reference signal or voltage of - in this embodiment - 4.0000V. Via another communication port of the aforementioned BMS chip 150, the BMS chip 150 is electrically connected to one of the plurality of the communication ports of the BMS chip 150 of the CSC 180 that comes next within the daisy chain, wherein also a communication wire COMw is used for the electrical connection. In fact, the electrical connections between the CSCs 180 of the daisy chain shown in figure 5 and thus the electrical connections between the BMS chips 150 of the aforementioned CSCs 180 is provided via communication wires COMw.

Therefore, for a calibration of the BMS chips 150 of CSCs 180 which are arranged in a daisy chain configuration as shown in figure 5, the BMS chips 150 of the CSCs 180 connected to the Battery Monitor Unit 400 have to connect their input ports with their output ports respectively, so that a corresponding following CSC 180 / BMS chip 150 in the daisy chain is also provided with the reference signal or voltage of 4.0000V and thus able to do the calibration. Within a finalized battery system 200 that is according to the invention, a calibration can be done continuously over the whole live time of the battery system 200, wherein only one accurate reference signal or voltage is needed, which can be for example continuously provided by the Battery Monitor Unit 400.

## Claims

1. A method for the manufacturing of a battery system (200), the method comprises the following steps:
- providing (S₁) a Battery Management System, BMS chip (150) with a volatile memory unit (115);
- assembling (S₂) a Printed Circuit Board, PCB (160);
- connecting and fixing (S₃) the BMS chip (150) to the PCB (160), to form a Cell Supervision Circuit, CSC (180);
- mounting (S₄) the CSC (180) onto one battery module (191) of a plurality of battery modules (190), connecting the PCB (160) of the CSC (180) to at least one battery cell (195) of the at least one battery module (191);
- electrically interconnecting (S₅) the at least one battery module (191) and another one of the plurality of battery modules (190) and electrically connecting the CSC (180) to a control unit (300), wherein
the step of mounting (S₄) and/or of electrically interconnecting (S₅) further comprises the step of calibrating (S₆) the BMS chip (150), wherein the step of calibrating (S₆) is performed when the BMS chip (150) is supplied with power from the at least one battery cell (195), the data resulting from the calibration being stored within the volatile memory unit (115).

2. The method of claim 1, further comprising the step of providing for a further CSC (180) to be mounted on the another one of the plurality of battery modules (190), wherein in the step of electrically interconnecting (S₅), also the CSCs (180) are electrically interconnected.

3. The method of any one of the preceding claims, wherein the step of connecting and fixing (S₃) comprises the step of soldering the BMS chip (150) to the PCB (160).

4. The method of any one of the preceding claims, wherein the provided BMS chip (150) comprises a plurality of channels (CHn) for the measurement of at least one battery cell parameter and a plurality of communication ports (COMn) for the communication with at least one external component, wherein the step of calibrating (S₆) comprises the step of triggering (S₆₋₁) a calibration process of the BMS chip (150) for an automatic calibration of the plurality of channels (CHn).

5. The method of claim 4, wherein in the step of calibrating (S₆), at least one of the communication ports (COMn) is used for the calibration of the BMS chip (150).

6. The method of claim 5, wherein the step of triggering (S₆₋₁) comprises detecting (S₆₋₂) a predefined signal supplied to the at least one of the communication ports (COMn).

7. The method of claim 6, wherein the predefined signal is a 4V direct current, DC signal.

8. The method of one of the claims 5 to 7, wherein the step of calibrating (S₆) further comprises the step of, consecutively to the step of triggering (S₆₋₁), using (S₆₋₃) the at least one of the communication ports (COMn) for the supply of an analog reference voltage in the calibration process triggered.

9. The method of claim 8, wherein as long as the step of calibrating (S₆) is performed, the at least one of the communication ports (COMn) is not used for a communication of or with the BMS chip (150).

10. The method of claim 8 or 9, wherein at least one of the channels (CHn) of the BMS chip (150) is connected to an input terminal of an Analog-to-Digital Converter, ADC (110) or to a multiplexer circuit (120) that is connected to an input terminal of an ADC (110) via a calibration switch (SWn) respectively, and wherein the calibration switch (SWn) allows to switch the input terminal of the ADC (110) of the BMS chip (150) to the at least one of the communication ports (COMn), wherein the step of calibrating (S₆) further comprises the step of switching (S₆₋₄) the input terminal of the ADC (110) of the BMS chip (150) to the at least one of the communication ports (COMn).

11. The method of any one of the preceding claims, further comprising the step of storing (S₆₋₅) the result of the calibration within the volatile memory unit (115) of the BMS chip (150).

12. A battery system (200), comprising
at least two battery modules (190) electrically interconnected via at least one bus bar (90), each battery module (190) comprising at least one battery cell (195);
a Cell Supervision Circuit, CSC (180) per battery module (190) respectively, each CSC (180) comprising a Printed Circuit Board, PCB (160), and a Battery Management System, BMS chip (150) comprising a volatile memory unit (115), respectively,
wherein
the battery system (200) has been manufactured with a method according to one of the claims 1 to 11.

13. The battery system (200) of claim 12, wherein the BMS chip (150) comprises
an Analog-to-Digital Converter, ADC (110) with an input terminal;
a plurality of channels (CHn) for the measurement of at least one battery cell parameter;
a plurality of communication ports (COMn) for the communication with at least one external component;
at least one calibration switch (SWn), adapted to electrically connect the input terminal of the ADC (110) to either one of the plurality of communication ports (COMn) or to at least one of the plurality of channels (CHn),
wherein the ADC (110) is adapted to be used within a calibration of the BMS chip (150).

14. The battery system (200) of claim 13, comprising at least two CSCs (180) with a BMS chip (150) respectively, wherein at least one of the plurality of the communication ports (COMn) of a first of the BMS chips (150) is electrically connected to a Battery Monitor Unit (400) providing for an accurate reference voltage and/or wherein at least one other one of the plurality of the communication ports (COMn) of the first of the BMS chips (150) is electrically connected to at least one of the plurality of communication ports (COMn) of the second of the BMS chips (150).

15. A vehicle including a battery system (200) according to one of the claims 12 to 14.

## Patentansprüche

1. Ein Verfahren zur Herstellung eines Batteriesystems (200), wobei das Verfahren die folgenden Schritte aufweist:
- Bereitstellen (S₁) eines Batteriemanagementsystem, BMS,-Chips (150) mit einer flüchtigen Speichereinheit (115);
- Anordnen (S₂) einer Leiterplatte, PCB, (160);
- Verbinden und Befestigen (S₃) des BMS-Chips (150) mit/an der PCB (160), um eine Zellenüberwachungsschaltung, CSC, (180) auszubilden;
- Anbringen (S₄) der CSC (180) auf einem Batteriemodul (191) einer Vielzahl von Batteriemodulen (190), Verbinden der PCB (160) der CSC (180) mit zumindest einer Batteriezelle (195) des zumindest einen Batteriemoduls (191);
- elektrisches Miteinander-Verbinden (S₅) des zumindest einen Batteriemoduls (191) und eines anderen der Vielzahl der Batteriemodule (190) und elektrisches Verbinden der CSC (180) mit einer Steuerungseinheit (300),
wobei
der Schritt des Anbringens (S₄) und/oder des elektrischen Miteinander-Verbindens (S₅) ferner den Schritt des Kalibrierens (S₆) des BMS-Chips (150) aufweist, wobei der Schritt des Kalibrierens (S₆) durchgeführt wird, wenn der BMS-Chip (150) mit Energie von der zumindest einen Batteriezelle (195) versorgt wird, wobei die aus der Kalibrierung resultierenden Daten in der flüchtigen Speichereinheit (115) gespeichert werden.

2. Das Verfahren nach Anspruch 1, ferner aufweisend den Schritt des Bereitstellens einer weiteren CSC (180), die auf dem anderen der Vielzahl der Batteriemodule (190) angebracht werden soll, wobei im Schritt des elektrischen Miteinander-Verbindens (S₅) auch die CSCs (180) elektrisch miteinander verbunden werden.

3. Das Verfahren nach einem der vorhergehenden Ansprüche, wobei der Schritt des Verbindens und Befestigens (S₃) den Schritt des Lötens des BMS-Chips (150) an die PCB (160) aufweist.

4. Das Verfahren nach einem der vorhergehenden Ansprüche, wobei der bereitgestellte BMS-Chip (150) eine Vielzahl von Kanälen (CHn) zur Messung zumindest eines Batteriezellenparameters und eine Vielzahl von Kommunikationsports (COMn) zur Kommunikation mit zumindest einer externen Komponente aufweist, wobei der Schritt des Kalibrierens (S₆) den Schritt des Auslösens (S₆₋₁) eines Kalibriervorgangs des BMS-Chips (150) für eine automatische Kalibrierung der Vielzahl der Kanäle (CHn) aufweist.

5. Das Verfahren nach Anspruch 4, wobei im Schritt des Kalibrierens (S₆) zumindest einer der Kommunikationsports (COMn) zur Kalibrierung des BMS-Chips (150) verwendet wird.

6. Das Verfahren nach Anspruch 5, wobei der Schritt des Auslösens (S₆₋₁) Erfassen (S₆₋₂) eines vordefinierten Signals, das zu zumindest einem der Kommunikationsports (COMn) geliefert wird, aufweist.

7. Das Verfahren nach Anspruch 6, wobei das vordefinierte Signal ein 4V-Gleichstrom, DC,-Signal ist.

8. Das Verfahren nach einem der Ansprüche 5 bis 7, wobei der Schritt des Kalibrierens (S₆) ferner nach dem Schritt des Auslösens (S₆₋₁) den Schritt des Verwendens (S₆₋₃) des zumindest einen der Kommunikationsports (COMn) zur Zuführung einer analogen Referenzspannung im ausgelösten Kalibriervorgang aufweist.

9. Das Verfahren nach Anspruch 8, wobei, solange der Schritt des Kalibrierens (S₆) durchgeführt wird, der zumindest eine der Kommunikationsports (COMn) nicht für eine Kommunikation des oder mit dem BMS-Chip/s (150) verwendet wird.

10. Das Verfahren nach Anspruch 8 oder 9, wobei zumindest einer der Kanäle (CHn) des BMS-Chips (150) mit einem Eingangsanschluss eines Analog-Digital-Wandlers, ADC, (110) oder mit einer Multiplexerschaltung (120), die jeweils über einen Kalibrierschalter (SWn) mit einem Eingangsanschluss eines ADC (110) verbunden ist, verbunden ist, und wobei der Kalibrierschalter (SWn) es ermöglicht, den Eingangsanschluss des ADC (110) des BMS-Chips (150) auf den zumindest einen der Kommunikationsports (COMn) zu schalten, wobei der Schritt des Kalibrierens (S₆) ferner den Schritt des Schaltens (S₆₋₄) des Eingangsanschlusses des ADC (110) des BMS-Chips (150) auf den zumindest einen der Kommunikationsports (COMn) aufweist.

11. Das Verfahren nach einem der vorhergehenden Ansprüche, ferner aufweisend den Schritt des Speicherns (S₆₋₅) des Ergebnisses der Kalibrierung in der flüchtigen Speichereinheit (115) des BMS-Chips (150).

12. Ein Batteriesystem (200), aufweisend
zumindest zwei Batteriemodule (190), die über zumindest eine Sammelschiene (90) elektrisch miteinander verbunden sind, wobei jedes Batteriemodul (190) zumindest eine Batteriezelle (195) aufweist;
eine Zellenüberwachungsschaltung, CSC, (180) jeweils pro Batteriemodul (190), wobei jede CSC (180) eine Leiterplatte, PCB, (160) und einen Batteriemanagementsystem, BMS,-Chip (150), der jeweils eine flüchtige Speichereinheit (115) aufweist, aufweist,
wobei
das Batteriesystem (200) mit einem Verfahren nach einem der Ansprüche 1 bis 11 hergestellt wurde.

13. Das Batteriesystem (200) nach Anspruch 12, wobei der BMS-Chip (150) aufweist
einen Analog-Digital-Wandler, ADC, (110) mit einem Eingangsanschluss;
eine Vielzahl von Kanälen (CHn) zur Messung zumindest eines Batteriezellenparameters;
eine Vielzahl von Kommunikationsports (COMn) zur Kommunikation mit zumindest einer externen Komponente;
zumindest einen Kalibrierschalter (SWn), der angepasst ist, um den Eingangsanschluss des ADC (110) entweder mit einem der Vielzahl der Kommunikationsports (COMn) oder mit zumindest einem der Vielzahl der Kanäle (CHn) elektrisch zu verbinden,
wobei der ADC (110) angepasst ist, um in einer Kalibrierung des BMS-Chips (150) verwendet zu werden.

14. Das Batteriesystem (200) nach Anspruch 13, aufweisend zumindest zwei CSCs (180) mit jeweils einem BMS-Chip (150), wobei zumindest einer der Vielzahl der Kommunikationsports (COMn) eines ersten der BMS-Chips (150) mit einer Batterieaufsichtseinheit (400), die eine korrekte Referenzspannung bereitstellt, elektrisch verbunden ist, und/oder wobei zumindest ein anderer der Vielzahl der Kommunikationsports (COMn) des ersten der BMS-Chips (150) mit zumindest einem der Vielzahl der Kommunikationsports (COMn) des zweiten der BMS-Chips (150) elektrisch verbunden ist.

15. Ein Fahrzeug, aufweisend ein Batteriesystem (200) nach einem der Ansprüche 12 bis 14.

## Revendications

1. Procédé pour la fabrication d'un système de batterie (200), le procédé comprend les étapes suivantes :
- fournir (S₁) une puce de système de gestion de batterie, BMS, (150) avec une unité de mémoire volatile (115) ;
- assembler (S₂) une carte de circuit imprimé, PCB (160) ;
- connecter et fixer (S₃) la puce BMS (150) à la PCB (160), pour former un circuit de supervision de cellule, CSC (180) ;
- monter (S₄) le CSC (180) sur un module de batterie (191) d'une pluralité de modules de batterie (190), connecter la PCB (160) du CSC (180) à au moins un élément de batterie (195) de l'au moins un module de batterie (191) ;
- interconnecter électriquement (S₅) l'au moins un module de batterie (191) et un autre de la pluralité de modules de batterie (190) et connecter électriquement le CSC (180) à une unité de commande (300),
dans lequel
l'étape de montage (S₄) et/ou d'interconnexion électrique (S₅) comprend en outre l'étape consistant à étalonner (S₆) la puce BMS (150), où l'étape d'étalonnage (S₆) est réalisée lorsque la puce BMS (150) est alimentée en énergie par l'au moins un élément de batterie (195), les données résultant de l'étalonnage étant stockées dans l'unité de mémoire volatile (115).

2. Procédé de la revendication 1, comprenant en outre l'étape consistant à fournir un CSC (180) supplémentaire à monter sur l'autre de la pluralité de modules de batterie (190), où, à l'étape d'interconnexion électrique (S₅), les CSC (180) sont également interconnectés électriquement.

3. Procédé de l'une quelconque des revendications précédentes, dans lequel l'étape de connexion et de fixation (S₃) comprend l'étape consistant à souder la puce BMS (150) à la PCB (160).

4. Procédé de l'une quelconque des revendications précédentes, dans lequel la puce BMS (150) fournie comprend une pluralité de canaux (CHn) pour la mesure d'au moins un paramètre d'élément de batterie, et une pluralité de ports de communication (COMn) pour la communication avec au moins un composant externe, dans lequel l'étape d'étalonnage (S₆) comprend l'étape consistant à déclencher (S₆₋₁) un processus d'étalonnage de la puce BMS (150) pour un étalonnage automatique de la pluralité de canaux (CHn).

5. Procédé de la revendication 4, dans lequel, à l'étape d'étalonnage (S₆), au moins un des ports de communication (COMn) est utilisé pour l'étalonnage de la puce BMS (150).

6. Procédé de la revendication 5, dans lequel l'étape de déclenchement (S₆₋₁) comprend la détection (S₆₋₂) d'un signal prédéfini alimentant l'au moins un des ports de communication (COMn).

7. Procédé de la revendication 6, dans lequel le signal prédéfini est un signal de courant continu, CC, de 4 V.

8. Procédé de l'une des revendications 5 à 7, dans lequel l'étape d'étalonnage (S₆) comprend en outre l'étape consistant à, consécutivement à l'étape de déclenchement (S₆₋₁) , utiliser (S₆₋₃) l'au moins un des ports de communication (COMn) pour l'alimentation en une tension de référence analogique au cours du processus d'étalonnage déclenché.

9. Procédé de la revendication 8, dans lequel, tant que l'étape d'étalonnage (S₆) est en cours de réalisation, l'au moins un des ports de communication (COMn) n'est pas utilisé pour une communication de ou avec la puce BMS (150) .

10. Procédé de la revendication 8 ou 9, dans lequel au moins un des canaux (CHn) de la puce BMS (150) est connecté à une borne d'entrée d'un convertisseur analogique-numérique, ADC (110), ou à un circuit multiplexeur (120) qui est connecté à une borne d'entrée d'un ADC (110) via un commutateur d'étalonnage (SWn) respectivement, et dans lequel le commutateur d'étalonnage (SWn) permet de commuter la borne d'entrée de l'ADC (110) de la puce BMS (150) à l'au moins un des ports de communication (COMn), dans lequel l'étape d'étalonnage (S₆) comprend en outre l'étape consistant à commuter (S₆₋₄) la borne d'entrée de l'ADC (110) de la puce BMS (150) à l'au moins un des ports de communication (COMn).

11. Procédé de l'une quelconque des revendications précédentes, comprenant en outre l'étape consistant à stocker (S₆₋₅) le résultat de l'étalonnage dans l'unité de mémoire volatile (115) de la puce BMS (150).

12. Système de batterie (200), comprenant
au moins deux modules de batterie (190) interconnectés électriquement via au moins une barre omnibus (90), chaque module de batterie (190) comprenant au moins un élément de batterie (195) ;
un circuit de supervision de cellule, CSC (180) par module de batterie (190) respectivement, chaque CSC (180) comprenant une carte de circuit imprimé, PCB (160), et une puce de système de gestion de batterie, BMS, (150) comprenant une unité de mémoire volatile (115), respectivement,
où
le système de batterie (200) a été fabriqué selon un procédé selon l'une des revendications 1 à 11.

13. Système de batterie (200) de la revendication 12, dans lequel la puce BMS (150) comprend
un convertisseur analogique-numérique, ADC (110) avec une borne d'entrée ;
une pluralité de canaux (CHn) pour la mesure d'au moins un paramètre d'élément de batterie ;
une pluralité de ports de communication (COMn) pour la communication avec au moins un composant externe ;
au moins un commutateur d'étalonnage (SWn), adapté pour connecter électriquement la borne d'entrée de l'ADC (110) soit à l'un de la pluralité de ports de communication (COMn) soit à au moins un de la pluralité de canaux (CHn),
dans lequel l'ADC (110) est adapté pour être utilisé dans un étalonnage de la puce BMS (150).

14. Système de batterie (200) de la revendication 13, comprenant au moins deux CSC (180) avec une puce BMS (150) respectivement, dans lequel au moins un de la pluralité des ports de communication (COMn) d'une première des puces BMS (150) est connecté électriquement à une unité de moniteur de batterie (400) fournissant une tension de référence précise, et/ou dans lequel au moins un autre de la pluralité des ports de communication (COMn) de la première des puces BMS (150) est connecté électriquement à au moins un de la pluralité de ports de communication (COMn) de la deuxième des puces BMS (150).

15. Véhicule comportant un système de batterie (200) selon l'une des revendications 12 à 14.
